# EUROPEAN PATENT APPLICATION

(11) **EP 1 249 867 A2**
(43) Date of publication of application: **16.10.2002**
(21) Application number: 02100318.1
(22) Date of filing: 28.03.2002
(51) Int. Cl.: H01L 21/768

(54) **A metal barrier for copper interconnects that incorporates silicon in the metal barrier or at the copper/metal barrier interface**

(30) Priority: 30.03.2001 US 821940
(71) Applicant: Texas Instruments Incorporated, Dallas, Texas 75251 (US)
(72) Inventor: JIANG, Qiang-Tang, Austin TX 78735 (US); LU, Jiong-Ping, Richardson TX 75082 (US); Ganesan, Devarajan, Austin TX 78749 (US)
(74) Representative: Holt, Michael

(57) **Abstract**

A copper interconnect having a barrier layer (106, 206). A metal barrier layer may be co-deposited with Si to form barrier (106) or a metal barrier layer may be deposited followed by surface treatment with a Si-containing ambient to form barrier (206). The copper (110) is then deposited over the said barrier layer (106,206) with good adhesion.

## Description

### FIELD OF THE INVENTION

The invention is generally related to the field of interconnect layers in semiconductor devices and more specifically to diffusion barriers for copper interconnect layers.

### BACKGROUND OF THE INVENTION

As the density of semiconductor devices increases, the demands on interconnect layers for connecting the semiconductor devices to each other also increases. Therefore, there is a desire to switch from the traditional aluminum metal interconnects to copper interconnects. Unfortunately, suitable copper etches for a semiconductor fabrication environment are not readily available. To overcome the copper etch problem, damascene processes have been developed.

In a damascene process, IMD and ILD are formed first. The IMD and ILD are then patterned and etched. A barrier layer and a copper seed layer are then deposited over the structure followed by Cu plating. One group of commonly used barrier layer material is the transition metal. The copper is then chemically-mechanically polished (CMP'd) to remove the copper from over the IMD, leaving copper interconnect lines. A metal etch is thereby avoided.

A barrier layer is required because copper has high diffusivity through common dielectric materials and Si. Copper interconnects totally rely on the encapsulating barrier materials to prevent copper from diffusing through to cause leakage and transistor poisoning. The basic requirements for the barrier materials are 1) good barrier efficiency, 2) good copper wettability, 3) strong copper to barrier bonding and 4) low electrical resistivity. The most commonly used metal barrier materials include Ta, Ti, W, etc. Most of the above metal barrier materials have limited adhesion strength with Cu. Cu agglomeration often occurs on metal barriers. The weak adhesion causes many problems. Most of the electromigration interfacial failures are attributable to the poor adhesion. Very often the via chain yield loss results from the weak bonding of Cu to metal barrier both at the via bottom and at the sidewalls. It is obvious that the Cu to barrier bonding has to be enhanced in order to increase the product yield and to improve the device reliability.

### SUMMARY OF THE INVENTION

The invention is a copper interconnect having a silicon containing metal barrier layer. Silicon is incorporated into at least a portion of a barrier layer either by co-depositing silicon and the barrier material or by treating the barrier layer with silicon containing gas after deposition. Copper is then deposited over the silicon containing barrier layer.

An advantage of this invention is providing a diffusion barrier having improved adhesion with copper, low resistance, and that can be fabricated using a method that offers high throughput and is easy to implement.

This and other advantages will be apparent to those of ordinary skill in the art having reference to the specification in conjunction with the drawings.

### BRIEF DESCRIPTION OF THE DRAWINGS

In the drawings:
FIG. 1 is a cross-sectional diagram of a copper interconnect layer having a silicon containing diffusion barrier according to a first embodiment of the invention;
FIG. 2A-2D are cross-sectional diagrams of the interconnect of FIG. 1 at various stages of fabrication, according to the invention;
FIG. 3 is a cross-sectional diagram of a copper interconnect layer having silicon incorporated into the copper/barrier interface according to a second embodiment of the invention; and
FIG. 4A-4D are cross-sectional diagrams of the copper interconnect of FIG. 3 at various stages of fabrication.

### DETAILED DESCRIPTION OF THE EMBODIMENTS

The invention will now be described in conjunction with a copper interconnect layer. Those of ordinary skill in the art will realize that the benefits of the invention may be applied to diffusion barriers in general where improved wetting property is desired without a significant increase in resistance.

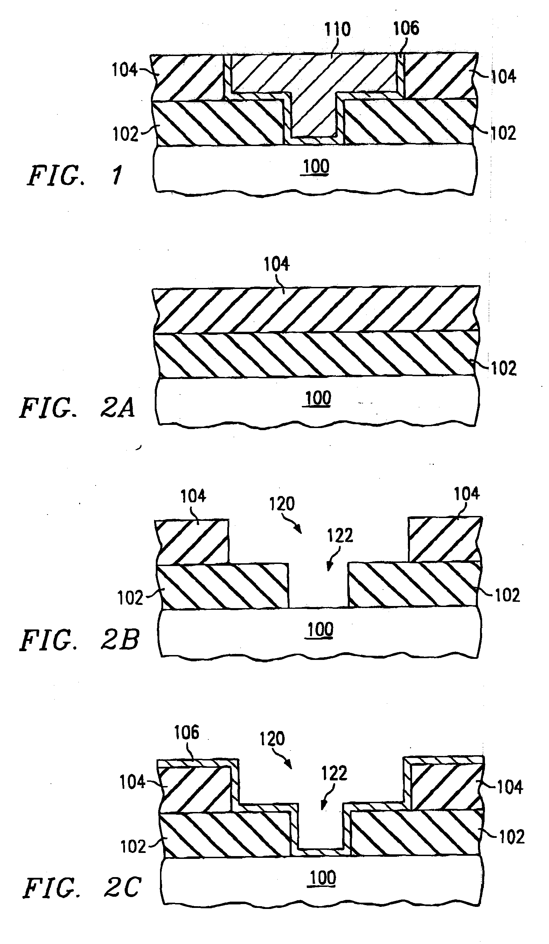

A diffusion barrier 106, according to a first embodiment of the invention, is shown in FIG. 1. An interlevel dielectric (ILD) 102 and intrametal dielectric (IMD) 104 are located over a semiconductor body 100. Semiconductor body 100 comprises transistors (not shown) and isolation structures (not shown) formed herein. Semiconductor body 100 may also comprise other devices and structures as are known in the art. Semiconductor body 100 may include additional interconnect layers (not shown) and/or additional interconnect layers may subsequently be formed over IMD 104.

Suitable materials for ILD 102 and IMD 104 are known in the art. ILD 102 and IMD 104 may comprise the same or differing materials. For example, ILD 102 and IMD 104 may comprise a PETEOS (Plasma Enhanced TetraEthyOxySilane) oxide or a low-k material such as xerogel, FSG (fluorine-doped silicate glass), HSQ (Hydrogen SilesQuixane), organic low-k materials, or a combination thereof.

Diffusion barrier 106 is located within ILD 102 and IMD 104. Diffusion barrier 106 contains Si in a transition metal such as Ta, Ti, W, Mo, Cr, etc. The Si in the barrier can be in the form of silicide, silicate, or silicon atoms. Copper 110 is located over barrier 106. The transition metal-silicon diffusion barrier 106 has low resistance and excellent wettability to dielectrics such as FSG. The copper to metal barrier bonding is significantly enhanced when silicon is present at the interface. Furthermore, while copper to metal barrier bonding deteriorates quickly when a small amount of O₂ is present, the silicon-enhanced copper to metal barrier bonding is not vulnerable to O₂

A method for forming diffusion barrier 106, according to the first embodiment of the invention, will now be discussed with reference to FIGs. 2A-2D. Referring to Fig. 2A, semiconductor body 100 is processed through the formation of ILD 102 and IMD 104. This includes the formation of isolation structures, transistors and other desired devices, as is known in the art. Suitable methods for forming ILD 102 and IMD 104 are known in the art. ILD 102 and IMD 104 may comprise the same or differing materials. For example, ILD 102 and IMD 104 may comprise a PETEOS oxide or a low-k material such as xerogel, FSG, HSQ, organic low-k materials, or a combination thereof. IMD 104 may be part of the first interconnect layer or any subsequent interconnect layer.

Referring to FIG. 2B, a trench 120 is etched in IMD 104. If vias are desired and have not already been formed, a dual damascene process may be used to form both trench 120 in IMD 104 and a via 122 in ILD 102. If via connections have already been fabricated, only trench 120 is etched.

Next, a diffusion barrier 106 can be deposited by physical vapor deposition (PVD), chemical vapor deposition (CVD), atomic layer deposition (ALD), etc. The diffusion barrier 106 is formed on the surface of IMD 104 and on the surface of trench 120, as shown in FIG. 2C. Diffusion barrier 106 is also formed on the surface of via 122, if a via connection has not already been formed. Diffusion barrier 106 contains Si in a transition metal such as Ta, Ti, W, Mo, Cr, etc. The Si in the barrier can be in the form of silicide, silicate, or silicon atoms. The thickness of diffusion barrier 106 is on the order of 20-500 Å on flat field.

The barrier layer 106 may be formed by co-depositing Si and the metal barrier layer. In this approach, a Si-containing ambient may be used to co-deposit the Si together with the barrier layer deposition. As an example, silicon-containing gases such as SiH₄, Si₂H₆, or Si(NR₃)₄, where R is an organic ligand may be used. The amount of Si incorporated in the barrier film 106 can be controlled by the gas flow of the silicon containing gas. This method gives total flexibility of the Si concentration in the barrier film 106. If desired, a linear or non-linear gradient of Si concentration can be generated inside the barrier film 106 by varying the gas flow during deposition.
Barrier film 106 can be deposited using low temperatures (i.e., < ~350°C). Low temperatures are more compatible with multilayer interconnect processing technology.

The Si containing barrier provides good wettability to the subsequently formed copper. The above method for forming the silicon containing barrier is an in-situ process that allows higher throughput than ex-situ processes. No vacuum break is needed which eliminates the formation of a barrier oxide.

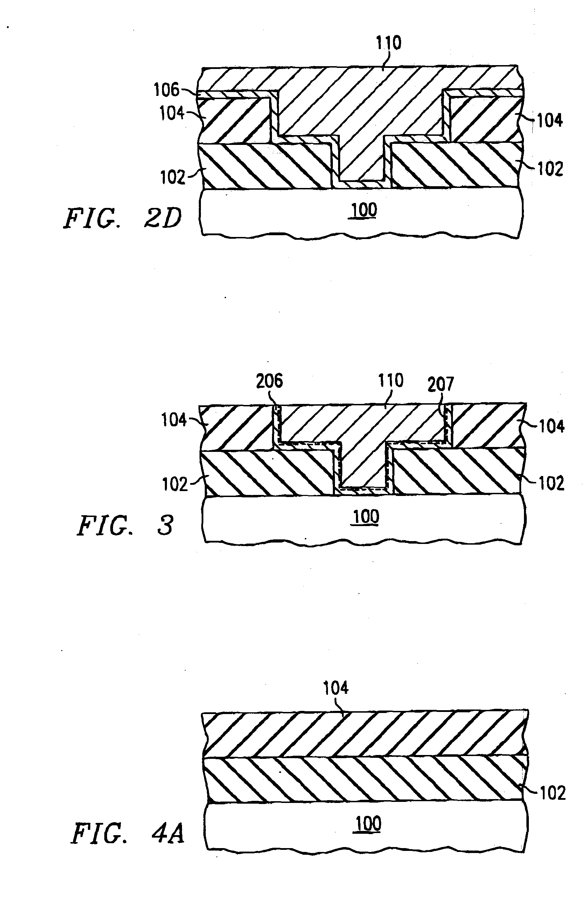

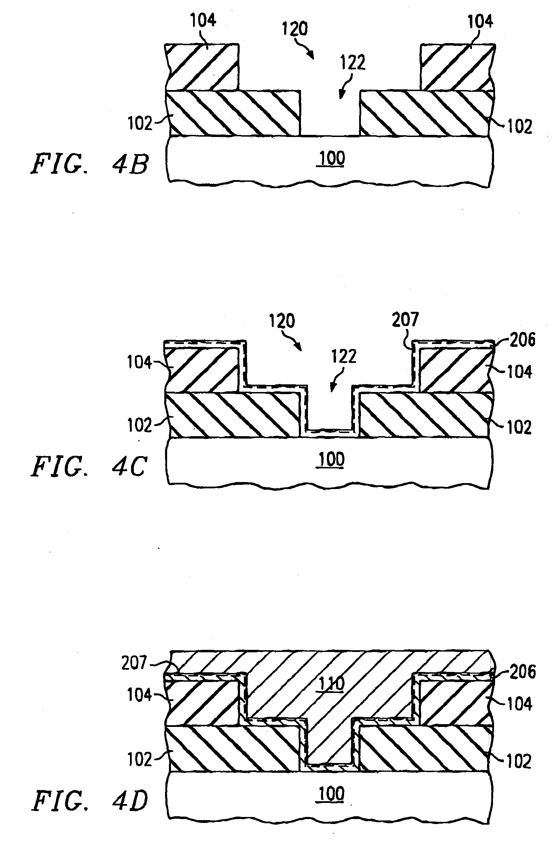

Referring to FIG. 2D, a copper layer 110 is formed on the barrier layer 106. Copper layer 110 may be formed by first forming a copper seed layer and then using an electroplating process to deposit the remaining copper. The silicon in barrier layer 106 may form a copper-silicide and/or copper-silicate at the interface. Both copper-silicide and copper silicate further improve adhesion and are expected to increase electromigration lifetimes.

The copper layer 110 and barrier layer 106 are then removed back, for example by CMP (chemical-mechanical polish) to substantially planar with IMD 104, as shown in FIG. 1.

The silicon containing barrier layer 106 may be applied to the first or any subsequent copper interconnect layer. Furthermore, it may be applied to one, some, or all of the copper interconnect layers.

A barrier layer 206, according to a second embodiment of the invention, is shown in FIG. 3. As in the first embodiment, ILD 102 and IMD 104 are located over semiconductor body 100. Suitable materials for ILD 102 and IMD 104 are known in the art. ILD 102 and IMD 104 may comprise the same or differing materials. For example, ILD 102 and IMD 104 may comprise a PETEOS oxide or a low-k material such as xerogel, FSG, HSQ, organic low-k materials, or a combination thereof.

Diffusion barrier 206 is located within ILD 102 and IMD 104. Diffusion barrier 206 comprises a barrier layer such as Ta, Ti, W, Mo, Cr, etc with silicon incorporated at the copper/barrier interface 207. Copper 110 is located over barrier 206. The silicon containing diffusion barrier 206 has low resistance and excellent wettability to Cu and to dielectrics such as FSG.

A method for forming diffusion barrier 206, according to the second embodiment of the invention, will now be discussed with reference to FIGs. 4A-4D. Referring to Fig. 4A, semiconductor body 100 is processed through the formation of ILD 102 and IMD 104. This includes the formation of isolation structures, transistors and other desired devices, as is known in the art. Suitable methods for forming ILD 102 and IMD 104 are known in the art. ILD 102 and IMD 104 may comprise the same or differing materials. For example, ILD 102 and IMD 104 may comprise a PETEOS oxide or a low-k material such as xerogel, FSG, HSQ, organic low-k materials, or a combination thereof. IMD 104 may be part of the first interconnect layer or any subsequent interconnect layer.

Referring to FIG. 4B, a trench 120 is etched in IMD 104. If vias are desired and have not already been formed, a dual damascene process may be used to form both trench 120 in IMD 104 and a via 122 in ILD 102. If via connections have already been fabricated, only trench 120 is etched.

Next, a diffusion barrier 206 can be deposited by physical vapor deposition (PVD), chemical vapor deposition (CVD), atomic layer deposition (ALD), etc. The diffusion barrier 206 is formed on the surface of IMD 104 and on the surface of trench 120, as shown in FIG. 4C. Diffusion barrier 206 is also formed on the surface of via 122, if a via connection has not already been formed. Diffusion barrier 206 contains Si in a transition metal such as Ta, Ti, W, Mo, Cr etc. The Si in the barrier can be in the form of silicide, silicate, or silicon atoms. The thickness of diffusion barrier 206 is in the range from 20 Å to 500 Å on flat field.

The barrier layer 206 may be formed by depositing a barrier layer such as Ta, Ti, W, Mo, Cr, etc and then treating the surface of the barrier layer with a silicon-containing gas. Suitable silicon-containing gases include SiH₄, Si₂H₆, or Si(NR₃)₄, where R is an organic ligand.

Barrier film 206 can be deposited and subjected to Si-containing gas treatment at low temperatures (i.e., < ~350°C). Low temperatures are more compatible with multilayer interconnect processing technology.

Referring to FIG. 4D, a copper layer 110 is formed on the barrier layer 206. Copper layer 110 may be formed by first forming a copper seed layer and then using an electroplating process to deposit the remaining copper. The silicon in barrier layer 206 may form a copper-silicide and /or copper-silicate at the interface. Both copper-silicide and copper-silicate further improve adhesion and are expected to increase electromigration lifetimes.

The copper layer 110 and barrier layer 206 are then removed back, for example by CMP (chemical-mechanical polish) to substantially planar with IMD 104, as shown in FIG. 3.

The silicon containing diffusion barrier 206 may be applied to the first or any subsequent copper interconnect layer. Furthermore, it may be applied to one, some, or all of the copper interconnect layers.

While this invention has been described with reference to illustrative embodiments, this description is not intended to be construed in a limiting sense. Various modifications and combinations of the illustrative embodiments, as well as other embodiments of the invention, will be apparent to persons skilled in the art upon reference to the description. It is therefore intended that the appended claims encompass any such modifications or embodiments.

## Claims

1. A method of fabricating a diffusion barrier for a copper interconnect, comprising the step of:
incorporating silicon in at least a portion of a metal barrier layer.

2. The method of claim 1, wherein said incorporating step comprises co-depositing silicon and a barrier material.

3. The method of claim 2, wherein said co-depositing step is performed in a silicon-containing ambient.

4. The method of claim 3, wherein said silicon-containing ambient is formed by supplying a silicon-containing gas selected from the group consisting of SiH₄, Si₂H₆, and Si(NR₃)₄, where R is an organic ligand.

5. The method of any preceding claim, wherein said incorporating step comprises the steps of:
depositing the metal barrier layer; and
treating a surface of said metal barrier layer with a silicon-containing gas.

6. The method of claim 5, wherein said metal barrier layer is selected from the group consisting of Ta, Ti, W, Mo, and Cr.

7. The method of claim 5 or claim 6, wherein said silicon-containing gas is selected from the group consisting of SiH₄, Si₂H₆, and Si(NR₃)₄, where R is an organic ligand.

8. The method of any preceding claim, wherein said diffusion barrier comprises Ta with Si incorporated therein.

9. The method of any preceding claim, wherein said diffusion barrier comprises W with Si incorporated therein.

10. The method of any preceding claim, wherein said diffusion barrier comprises Ti with Si incorporated therein.

11. The method of any preceding claim, wherein said barrier layer has a flat field thickness on the order of 20-500Å.

12. A method of fabricating an integrated circuit, comprising the steps of:
forming a dielectric layer over a semiconductor body;
etching a trench in said dielectric layer;
forming a metal barrier layer over said dielectric layer including within said trench by depositing a transition metal in a silicon-containing ambient; and
forming a copper layer on said metal barrier layer.

13. The method of claim 12, wherein said transition metal comprises a material selected from the group consisting of Ta, Ti, W, Mo, and Cr.

14. The method of claim 12 or claim 13, wherein said silicon-containing ambient is formed by supplying a silicon-containing gas selected from the group consisting of SiH₄, Si₂H₆, and Si(NR₃)₄, where R is an organic ligand.

15. The method of claim 12 or claim 13 or claim 14, wherein said barrier layer has a flat field thickness on the order of 20-500 Å.

16. A method of fabricating an integrated circuit, comprising the steps of:
forming a dielectric layer over a semiconductor body;
etching a trench in said dielectric layer;
forming a metal barrier layer over said dielectric layer including within said trench;
treating a surface of said metal barrier layer with a silicon-containing ambient; and
forming a copper layer on said surface of said metal barrier layer.

17. The method of claim 16, wherein said silicon-containing ambient comprises a plasma.

18. The method of claim 16, wherein said silicon-containing ambient is formed by supplying a silicon-containing gas selected from the group consisting of SiH₄, Si₂H₆, and Si(NR₃)₄, where R is an organic ligand.
